# FASCICULE DE BREVET EUROPEEN

(11) **EP 1 582 001 B1**
(45) Date de publication et mention de la délivrance du brevet: **26.10.2011**
(21) Numéro de dépôt: 03780500.9
(22) Date de dépôt: 19.12.2003
(51) Int. Cl.: H04B 1/00

(54) **INSTALLATION PERMETTANT L'ECHANGE D'INFORMATIONS ENTRE UN EMETTEUR ET UN RECEPTEUR**
INFORMATIONSAUSTAUSCHANORDNUNG ZWISCHEN EIN SENDERGERÄT UND EIN EMPFÄNGERGERÄT
DEVICE FOR DATA EXCHANGE BETWEEN A TRANSMITTER AND A RECEIVER

(30) Priorité: 10.01.2003 FR 0300263
(43) Date de publication de la demande: 05.10.2005
(73) Titulaire: Somfy S.A.S., 74300 Cluses (FR)
(72) Inventeur: HEILIG, Marcus, 72116 Mössingen (DE)
(74) Mandataire: Kiliaridis, Constantin
(86) Numéro de dépôt international: PCT/IB2003/006277
(87) Numéro de publication internationale: WO 2004/064256

(56) Documents cités:
- WO-A-93/18609
- US-A- 5 592 510
- US-A- 5 657 346
- US-A- 6 034 551
- US-A- 6 084 457

## Description

L'invention concerne une installation d'échange d'informations comprenant un émetteur alimenté par une alimentation, un câble électrique dont un premier conducteur est connecté à un point de potentiel fixe de l'émetteur et dont un second conducteur est connecté à un point de potentiel variable de l'émetteur et au moins un récepteur.

De telles installations sont largement utilisées pour échanger des informations. Elles nécessitent, d'une part, l'utilisation de câbles blindés ou des paires de fils torsadés, protégés contre les rayonnements électromagnétiques et, d'autre part, l'utilisation de circuits de génération des signaux constituant les informations et de mise en forme de ces signaux. On connaît, par exemple; des installations de transmission de données utilisant les normes EIB (marque déposée), LONWORKS (marque déposée) ou RS485. De tels systèmes sont très performants et permettent de transmettre des informations avec un débit élevé. Cependant, ces installations sont surdimensionnées pour certaines applications dans lesquelles, en particulier, un débit élevé n'est pas un critère important.

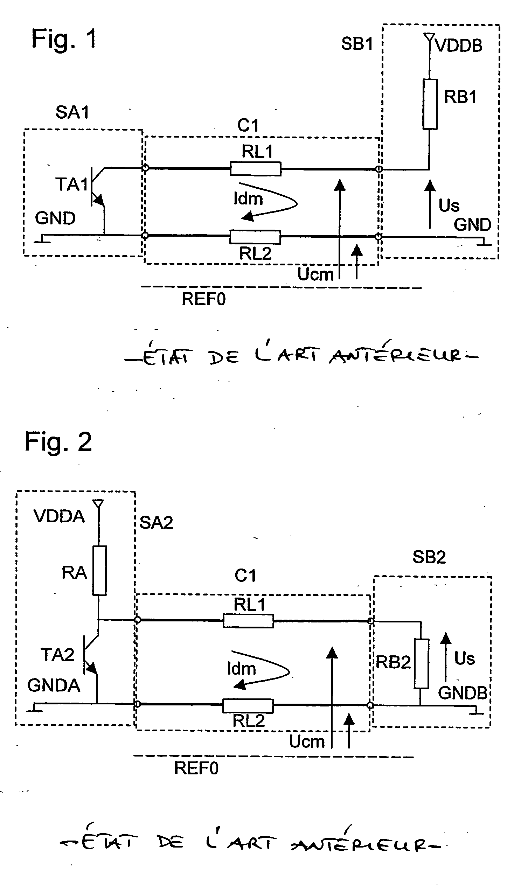

Des installations plus simples sont connues de l'art antérieur. Par exemple, on connaît un ensemble tel que représenté à la figure 1. Cet ensemble comprend un émetteur SA1 et un récepteur SB1 reliés l'un à l'autre par un câble électrique C1 à deux conducteurs dont les résistances électriques sont symbolisées par les résistances RL1 et RL2. L'émetteur comprend principalement un interrupteur commandé constitué par un transistor TA1 fonctionnant en commutation et permettant de connecter entre elles ou non les deux extrémités des conducteurs du câble électrique. Le récepteur SB1 comprend quant à lui une alimentation fournissant une tension VDDB reliée à l'extrémité de l'un des conducteurs du câble électrique via une résistance RB1. Une tension Us est mesurée entre les extrémités des conducteurs du câble électrique. Cette tension Us varie suivant l'état du transistor de l'émetteur SA1. Ainsi, une information est codée en une succession d'états du transistor TA1 au niveau de l'émetteur et décodée par la mesure des variations de la tension Us au niveau du récepteur SB1. Lorsque le transistor TA1 est passant, l'intensité dans le câble électrique reliant l'émetteur et le récepteur est principalement limitée par la résistance RB1. Le débit d'information étant assez bas, il est inutile de représenter sur ce schéma les effets capacitifs et inductifs d'un tel montage.

Une telle installation présente des inconvénients. En effet, si on envisage de connecter 100 récepteurs avec l'émetteur SA1 sur la même ligne, les résistances de limitation de courant se retrouvent montées en parallèle et leur valeur vaut alors RB1/100. Afin d'éviter de faire circuler des courants trop importants dans le transistor TA, on est alors obligé de limiter le nombre d'éléments pouvant communiquer entre eux ou de choisir une résistance RB1 importante, par exemple 100 fois la valeur provoquant le courant maximal admissible par le transistor TA.

On sait que des tensions de mode commun et de mode différentiel apparaissent au niveau des émetteurs et des récepteurs de telles installations, en particulier lorsque ceux-ci sont éloignés les uns des autres.

Les tensions de mode commun sont représentées par les flèches Ucm. Du fait de la résistance RB1, un courant de mode commun provoque nécessairement une modification de la tension Us.

Les tensions de mode différentiel sont provoquées par des courants Idm circulant dans la boucle formée par les deux conducteurs du câble électrique entre l'émetteur et le récepteur. Ces courants traversant les résistances RL1 et RL2 contribuent eux aussi à modifier la tension Us.

Pour réduire les effets des courants induits parasites Idm, des câbles électriques blindés ou torsadés sont utilisés. On utilise de plus des conducteurs présentant une très faible résistance et on restreint l'éloignement admissible entre les différents éléments de l'installation.

Un compromis doit être trouvé sur la valeur de la résistance RB1. Sa valeur doit être élevée pour permettre une communication entre un maximum d'éléments et de maintenir, lorsque le transistor TA1 est passant, une tension Us inférieure au seuil supérieur de la valeur logique basse de n'importe quel circuit logique utilisant cette tension. Inversement, sa valeur doit être faible pour limiter les effets des courants induits.

On connaît encore des installations telles que celle représentée à la figure 2. Cet ensemble comprend un émetteur SA2 et un récepteur SB2 reliés l'un à l'autre par un câble électrique C1 à deux conducteurs dont les résistances électriques sont symbolisées par les résistances RL1 et RL2. L'émetteur SA2 comprend principalement une alimentation fournissant une tension VDDA alimentant une résistance RA et un transistor TA2 montés en série. Le transistor TA2 est commandé par un circuit non représenté et fonctionne en commutation. Le récepteur SB2 présente principalement une résistance RB2 entre les extrémités des deux conducteurs du câble électrique. La tension Us est recueillie aux bornes de cette résistance. Ainsi, une information est codée en une succession d'états du transistor TA2 au niveau de l'émetteur et décodée par la mesure des variations de la tension Us au niveau du récepteur SB2. Lorsque le transistor TA2 est bloqué, l'intensité dans le câble électrique reliant l'émetteur et le récepteur est principalement limitée par la résistance RA.

Dans cette installation, la valeur de la résistance RB2 doit, elle aussi, être importante pour permettre la connexion d'un grand nombre d'éléments, la valeur de RA étant donnée. Elle doit aussi être bien supérieure aux valeurs des résistances RL1 et RL2. Cependant, la valeur de RB2 doit être aussi faible que possible pour réduire les effets des courants induits de mode commun et de mode différentiel.

Le but de l'invention est de réaliser une installation de transmission d'informations palliant les inconvénients cités et améliorant les installations connues de l'art antérieur. En particulier, l'invention se propose de réaliser une installation simple, dont les coûts de fabrication sont faibles, permettant de connecter entre eux de nombreux émetteurs et récepteurs et peu sensibles aux tensions et courants parasites.

L'installation d'échange d'informations selon l'invention est **caractérisée en ce que** le récepteur ou les récepteurs comprennent un composant définissant une tension seuil s'opposant à la circulation du courant électrique dans le câble ce composant comprenant une diode Zener alimentée par un courant permanent, tel qu'elle présente entre ses bornes une tension sensiblement égale à sa tension Zener même en l'absence de courant dans le cable. Ainsi, les tensions parasites doivent être supérieures à cette tension seuil pour entraîner la circulation d'un courant dans le câble et être interprétées comme des informations.

Les revendications dépendantes 2 à 3 définissent différentes variantes de réalisation de l'installation selon l'invention.

Le dessin annexé représente, à titre d'exemple, un mode de réalisation d'une installation d'échange d'informations selon l'invention.
Les figures 1 et 2 représentent des ensembles émetteur-récepteur connus de l'art antérieur reliés par des câbles électriques permettant l'échange d'informations.
La figure 3 représente une installation d'échange d'informations comprenant un émetteur et un récepteur reliés par un câble électrique.
La figure 4 représente un mode de réalisation d'une installation d'échange d'informations selon l'invention, comprenant un émetteur et un récepteur reliés par un câble électrique.

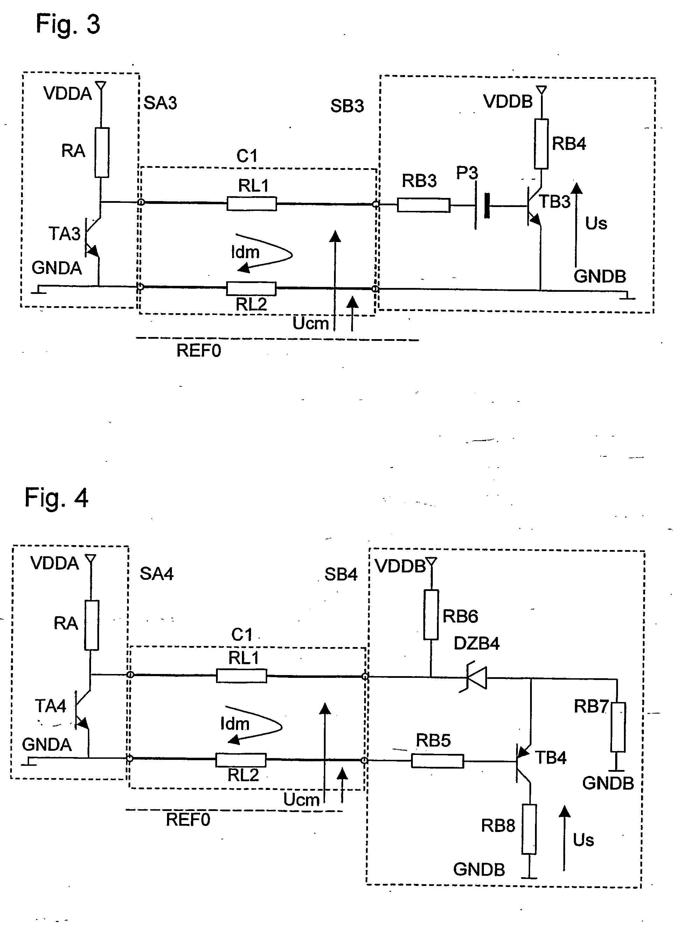

La figure 3 montre un émetteur SA3 et un récepteur SB3 reliés l'un à l'autre par un câble électrique à deux conducteurs dont les résistances électriques sont symbolisées par les résistances RL1 et RL2. L'émetteur SA3 comprend un transistor TA3 et est identique à l'émetteur SA2 précédemment décrit. Le récepteur SB3 comprend une alimentation de tension VDDB alimentant une résistance RB4 et un transistor TB3 montés en série. La base de l'émetteur TB3 est reliée à une extrémité d'un conducteur du câble électrique via un générateur de tension continue P3 tel qu'une pile ou un accumulateur électrique et une résistance RB3. Le transistor TA3 est commandé par un circuit non représenté et fonctionne en commutation. La tension Us est recueillie entre l'émetteur et le collecteur du transistor TB3.

Ainsi, une information est codée en une succession d'états du transistor TA3 au niveau de l'émetteur et décodée par la mesure des variations de la tension Us au niveau du récepteur SB2. Lorsque le transistor TA3 est bloqué, l'intensité dans le câble électrique reliant l'émetteur et le récepteur est principalement limitée par la résistance RB3.

Avec un tel montage on peut choisir une forte résistance RB3 tout en étant peu sensible aux effets des courants induits. Le transistor TB3 reste, en effet, bloqué tant que la tension de mode différentiel ne devient pas supérieure à la tension du générateur P3 augmentée de la tension entre la base et l'émetteur du transistor TB3.

Par exemple, les tensions VDDA et VDDB des alimentations de l'émetteur SA3 et du récepteur SB3 peuvent être prises égales à 12 V. Les résistances RA et RB4 peuvent être prises égales à 1 kΩ et RB3 égale à 50 kΩ pour permettre la connexion de nombreux éléments entre-eux. La tension du générateur peut être prise égale à 4.5 V et la tension base-émetteur du transistor TB3 égale à 0.6 V.

Ainsi, la tension différentielle permettant le changement d'état du transistor vaut sensiblement 5 V. Cette valeur donne une bonne marge de sécurité permettant d'empêcher les effets des courants induits.

Un tel montage présente l'inconvénient d'utiliser un générateur de tension continue tel qu'une pile électrique ou un accumulateur. Dans ce dernier cas, on remarquera cependant que l'accumulateur est rechargé en permanence à travers les résistances RA, RL1, RB3 et RL2 quand le transistor TA3 est ouvert, ce qui compense l'autodécharge et donne une grande durée de vie au composant.

On ne peut pas dans un tel circuit remplacer ce générateur par une diode Zener de tension Zener égale à 4.4 V pour s'affranchir des tensions parasites.

En effet, si l'on remplace le générateur P3 par une diode Zener, lorsque le transistor TA3 est bloqué, le courant est principalement limité par la résistance RB3 et vaut sensiblement : (12-5)/50 = 0,140 mA. Une aussi faible valeur a pour conséquence que la tension aux bornes de la diode Zener est très différente de la tension Zener et est dans ce cas sensiblement nulle. Il en résulte que le circuit est sensible au courants induits.

Un mode de réalisation d'une installation selon l'invention est représenté à la figure 4 et permet de résoudre ce problème. Cette installation comprend un émetteur SA4 et un récepteur SB4 reliés l'un à l'autre par un câble électrique C1 à deux conducteurs dont les résistances électriques sont symbolisées par les résistances RL1 et RL2. Des informations constituées de signaux électriques envoyés sur le câble électrique peuvent êtres émises par l'émetteur SA4 et être reçues par le récepteur SB4. Un seul émetteur et un seul récepteur ont été représentés à la figure 4 dans un but simplification et de clarté. Cependant, il est évident que l'installation peut comprendre plusieurs émetteurs d'ordres et plusieurs récepteurs d'ordres reliés en parallèle sur le câble électrique. Une telle installation permet par exemple dans un réseau domotique la communication entre des dispositifs de commande, des équipements électriques et des capteurs. Chacun de ses éléments peut comprendre un émetteur et un récepteur afin de pouvoir réaliser des communications bidirectionnelles entre eux.

L'émetteur SA4 comprend principalement une alimentation fournissant une tension VDDA alimentant une résistance RA et un transistor TA4 montés en série. Le transistor TA4 est commandé par un circuit non représenté et fonctionne en commutation. Le récepteur SB4 comprend une alimentation fournissant une tension VDDB et alimentant une résistance RB6 et une diode Zener DZB4 montées en série avec deux branches parallèles comprenant respectivement, une résistance RB7, et un transistor TB4 et une résistance RB8 montés en série. L'une des deux extrémités des conducteurs du câble électrique est connectée entre la résistance RB6 et la diode Zener, l'autre est connectée à la base du transistor TB4 par l'intermédiaire d'une résistance RB5.

L'installation peut être réalisée, par exemple, avec les valeurs suivantes :
VDDA = VDDB = 12 V
RA = RB6 = 1 kΩ
UZ = 3.9V
RB5 = 47 kΩ
RB7 = 4.7 kΩ
RB8 = 100 kΩ

Une information qui doit être envoyée de l'émetteur SA4 au récepteur SB4 est codée en une succession temporelle d'états bloqués et passants du transistor TA4. Elle est décodée au niveau du récepteur SB4 par l'analyse des variations de la tension Us mesurée aux bornes de la résistance RB8.

Lorsque le transistor TA4 est bloqué, une tension est présente entre le collecteur et l'émetteur du transistor TA4. Cette tension vaut sensiblement une douzaine de volt. Elle entraîne la circulation d'un courant traversant la résistance RL1, la diode Zener DZB4, le transistor TB4, la résistance RB5 et la résistance RL2. La tension Zener de la diode DZB4 est maintenue par un courant circulant à travers les résistances RB6 et RB7 branchées entre les bornes d'alimentation du récepteur SB4. Cette tension Zener et la tension émetteur-base du transistor TB4 s'opposent à la circulation du courant dans le câble. Lorsqu'un courant suffisant circule dans ce câble, le transistor TB4 est passant et la tension Us vaut alors une dizaine de Volts et est interprétée comme un état haut par un circuit logique. La forte valeur de la résistance RB5 permet la limitation du courant et la possibilité de connecter un émetteur avec de nombreux récepteurs.

Lorsque le transistor TA4 est passant, la tension entre son collecteur et son émetteur est sensiblement nulle. Ceci a pour conséquence qu'aucun courant ne circule dans la boucle. Le transistor TB4 est par conséquent bloqué et la tension Us est sensiblement nulle. Elle est interprétée comme un état bas par un circuit logique. Le courant traversant la diode Zener et permettant de maintenir la tension Zener à ses bornes est choisi environ dix fois supérieur aux courants induits qu'il est possible de rencontrer dans le câble. Ceci permet d'assurer que des courants parasites induits ne puissent pas faire basculer le transistor TB4 dans un état passant.

Une telle installation comprenant une centaine de récepteurs et une longueur de 1000m de câble de connexion fonctionne parfaitement.

Les émetteurs et les récepteurs peuvent bien entendu comprendre d'autres éléments tels que des condensateurs. Le transistor TA4 peut, par exemple, être commandé par un microcontrôleur.

Pour permettre la connexion d'un nombre encore plus important d'élément dans l'installation, on peut encore remplacer la résistance RA par un transistor.

## Revendications

1. Installation d'échange d'informations comprenant un émetteur (SA4) alimenté par une alimentation (VDDA), un câble électrique (C1) dont un premier conducteur est connecté à un point de potentiel fixe (GNDA) de l'émetteur et dont un second conducteur est connecté à un point de potentiel variable de l'émetteur et au moins un récepteur (SB4), **caractérisée en ce que** le récepteur ou les récepteurs (SB4) comprennent un composant (DZB4) définissant une tension seuil s'opposant à la circulation du courant électrique dans le câble (C1), ce composant comprenant une diode Zener (DZB4) alimentée par un courant permanent, tel qu'elle présente entre ses bornes une tension sensiblement égale à sa tension Zener même en absence de courant dans le câble (C1).

2. Installation d'échange d'informations selon la revendication 1, **caractérisée en ce que** la tension de seuil s'opposant à la circulation du courant électrique dans le câble (C1) est la somme de la tension Zener de la diode Zener (DZB4) et de la tension émetteur-base d'un transistor (TB4) dont l'émetteur est relié à l'anode de la diode Zener (DZB4).

3. Installation d'échange d'informations selon l'une quelconque des revendications 1 à 2, **caractérisée en ce que** la tension seuil est supérieure à 2 Volts.

## Claims

1. An installation for exchanging information comprising a transmitter (SA4) supplied from a power supply (VDDA), an electric cable (C1) of which a first conductor is connected to a point of fixed potential (GNDA) of the transmitter and of which a second conductor is connected to a point of variable potential of the transmitter and at least one receiver (SB4), **characterized in that** the receiver or the receivers (SB4) comprise a component (DZB4) defining a threshold voltage opposing the flow of the electric current through the cable (C1), this component comprising a Zener diode (DZB4) supplied with a continuous current, such that between its terminals it exhibits a voltage substantially equal to its Zener voltage even in the absence of current in the cable (C1).

2. The installation for exchanging information as claimed in claim 1, **characterized in that** the threshold voltage opposing the flow of the electric current through the cable (C1) is the sum of the Zener voltage of the Zener diode (DZB4) and of the emitter-base voltage of a transistor (TB4) whose emitter is linked to the anode of the Zener diode (DZB4).

3. The installation for exchanging information as claimed in any one of claims 1 to 2, **characterized in that** the threshold voltage is greater than 2 volts.

## Patentansprüche

1. Einrichtung zum Austausch von Informationen, mit einem Sender (SA4), der von einer Speisung (VDDA) mit Energie versorgt wird, mit einem elektrischen Kabel (C1), von dem ein erster Leiter mit einem Punkt des Senders mit festem Potential (GNDA) und ein zweiter Leiter mit einem Punkt des Senders mit veränderlichem Potential verbunden ist, und mit mindestens einem Empfänger (SB4), **dadurch gekennzeichnet, dass** der oder die Empfänger (SB4) ein Bauteil (DZB4) enthalten, welches eine Schwellenspannung definiert, die gegen einem Stromfluss im Kabel (C1) entgegen gerichtet ist, wobei dieses Bauteil eine Zenerdiode (DZB4) aufweist, die von einem Dauerstrom beaufschlagt ist, derart, dass an den Anschlüssen der Diode eine Spannung anliegt, die praktisch gleich der Zenerspannung ist, auch wenn kein Strom im Kabel (C1) fliesst.

2. Einrichtung zum Austausch von Informationen nach Anspruch 1, **dadurch gekennzeichnet, dass** die Schwellenspannung, die einem elektrischen Stromfluss im Kabel (C1) entgegen gerichtet ist, die Summe der Zenerspannung der Zenerdiode (DZB4) und der Emitter-Basis-Spannung eines Transistors (TB4) ist, dessen Emitter mit der Anode der Zenerdiode (DZB4) verbunden ist.

3. Einrichtung zum Austausch von Informationen nach einem der Ansprüche 1 und 2, **dadurch gekennzeichnet, dass** die Schwellenspannung grösser ist als 2 Volt.
